# EUROPÄISCHE PATENTSCHRIFT

(11) **EP 2 504 862 B1**
(45) Veröffentlichungstag und Bekanntmachung des Hinweises auf die Patenterteilung: **28.02.2018**
(21) Anmeldenummer: 10776315.3
(22) Anmeldetag: 02.11.2010
(51) Int. Cl.: H01L 31/0392

(54) **SUBSTRAT MIT EINER METALLFOLIE ZUR HERSTELLUNG VON PHOTOVOLTAIK-ZELLEN**
SUBSTRATE WITH A METAL SHEET FOR PRODUCING PHOTOVOLTAIC CELLS
SUBSTRAT DOTÉ D'UNE FEUILLE DE MÉTAL DESTINÉE À LA FABRICATION DE CELLULES PHOTOVOLTAÏQUES

(30) Priorität: 26.11.2009 EP 09405208
(43) Veröffentlichungstag der Anmeldung: 03.10.2012
(73) Patentinhaber: Constellium Switzerland AG, 8048 Zürich (CH)
(72) Erfinder: AFSETH, Andreas, 38500 Coublevie (FR); GILLICH, Volkmar, 8212 Neuhausen (CH); STATTI, Josef, 78239 Rielasingen (DE); PLATTE, Ralf, 78224 Singen (DE); ANTOINE, Stephane, 68000 Colmar (FR)
(74) Vertreter: Constellium - Propriété Industrielle
(86) Internationale Anmeldenummer: PCT/EP2010/006658
(87) Internationale Veröffentlichungsnummer: WO 2011/063883

(56) Entgegenhaltungen:
- EP-A1- 2 048 266
- WO-A1-2005/017058
- WO-A2-2005/066388
- DE-A1- 10 113 782
- US-A- 5 175 027
- US-A- 6 124 039
- US-A1- 2008 308 148

## Beschreibung

Die Erfindung betrifft ein Substrat mit einer Metallfolie zur Herstellung von Photovoltaik-Zellen, wobei eine erste Seite der Metallfolie zur Anordnung einer Photovoltaik-Absorberschicht vorgesehen ist. Im Rahmen der Erfindung liegt auch eine Photovoltaik-Zelle mit einem derartigen Substrat.

Leistungsfähige photovoltaische Bauteile, wie Solarzellen, enthalten beispielsweise Absorberschichten aus Elementen der Gruppen IB, IIIA und VIA, z. B. Legierungen von Kupfer mit Indium und/oder Gallium oder Aluminium und Selen und/oder Schwefel. Eine übliche Kombination der vorgenannten Elemente ist Kupfer-Indium-Gallium-Diselenid (CIGS) und die daraus hergestellten Bauteile werden oft als CIGS-Solarzellen bezeichnet. Die CIGS-Absorberschicht kann auf einem Substrat abgeschieden werden. Wünschenswert wäre die Herstellung einer derartigen Absorberschicht auf einem Aluminiumfoliensubstrat, weil Aluminiumfolie verhältnismässig billig, leichtgewichtig und flexibel ist.

Aus US 2007/0000537 A1 sind Solarzellen mit einer auf einer Aluminiumfolie aufgebauten CIGS-Absorberschicht bekannt. Die auf die Aluminiumfolie aufgetragene Absorberschicht wird während mehreren Minuten bei einer Temperatur von bis zu 600°C geglüht. Sowohl während des Beschichtens bzw. Bedruckens des Substrats mit dem lösungsbasierten Absorbermaterial als auch beim nachfolgenden Aushärten bei erhöhter Temperatur ist die Aluminiumfolie dem Angriff chemischer Stoffe in dampf- und gasförmiger Form ausgesetzt. Die natürliche Oxidschicht des Aluminiums, aber auch elektrolytisch erzeugte Oxidschichten, weisen eine geringe chemische Beständigkeit bzw. einen geringen Korrosionswiderstand gegenüber den aggressiven Chemikalien auf. Hinzu kommt, dass eine Aluminiumfolie bei Einwirkung hoher Temperaturen weich wird und demzufolge eine verminderte mechanische Festigkeit aufweist.

Der Erfindung liegt die Aufgabe zugrunde, ein Substrat der eingangs genannten Art bereitzustellen, welches eine im Vergleich zu Substraten nach dem Stand grössere chemische Beständigkeit bzw. einen grösseren Korrosionswiderstand gegenüber den beider Herstellung photovoltaischer Zellen eingesetzten Chemikalien aufweist. Zudem soll das Substrat einfach und kostengünstig herstellbar sein, und die einfache Herstellung einer Solarzelle erlauben. Das Dokument US6124039 offenbart die Sol-Gel-Abscheidung von Schichten, die als Schutz vor Korrosion und Diffusionsbarriere zwischen dem Substrat und den PV-Schichten wirken.

Die Aufgabe der Erfindung wird durch den Gegenstand des Anspruchs 1 gelöst. Zur erfindungsgemässen Lösung der Aufgabe führt, dass zur Verbesserung der chemischen Beständigkeit und des Korrosionswiderstandes bei erhöhter Temperatur auf der zweiten Seite der Metallfolie eine Schutzschicht aus einem Silizium-basierten Sol-Gel-Lack angeordnet ist. Die Metallfolie wird zumindest auf der ersten Seite zur Erzielung einer Oberflächenrauhigkeit Ra < 100 nm (Nanometer), vorzugsweise Ra < 50 nm, hochglanzgewalzt und/oder elektrolytisch poliert.

Bevorzugt weist die Schutzschicht im getrockneten bzw. ausgehärteten Zustand eine Dicke zwischen etwa 0,5 und 4 µm auf.

Die Metallfolie ist eine Folie aus Aluminium Die Schutzschicht aus dem Sol-Gel-Lack hat neben der chemischen Beständigkeit den weiteren Vorteil, dass sie die bei Einwirkung hoher Temperaturen erweichende Aluminiumfolie stützt und ihr eine verbesserte mechanische Stabilität verleiht.

Bei der unmittelbar auf der Aluminiumfolie realisierten Schutzschicht handelt es sich um einen Sol-Gel-Lack, der hervorgegangen ist aus einem unmittelbar auf die Metallfolie aufgebrachten Sol-Gel-System. Als Gele bezeichnet man formbeständige, leicht deformierbare, an Flüssigkeit reichhaltige disperse Systeme, die aus einem festen, unregelmässigen, dreidimensionalen Netzwerk und einer Flüssigkeit bestehen. Unter einem Sol-Gel-System ist dabei ein nach der Sol-Gel-Technologie hergestellter Sol-Gel-Lack zu verstehen, der nach produktgerechter Applizierung und Aushärtung eine mit dem Substrat - in diesem Fall eine Metallfolie - fest verbundene, gehärtete Schutzschicht bildet. Die Schicht ist vorzugsweise ein transparent aushärtender Sol-Gel-Lack, der den farblichen Grundton des Substrates erkennen lässt. Unter transparent aushärtendem Sol-Gel-Lack ist insbesondere eine klare, farblose, durchsichtige Schicht zu verstehen. Die auf die gereinigte Oberfläche des Substrates aufgebrachte Schicht ist vorzugsweise ein Sol-Gel-Lack, insbesondere ein Sol-Gel-Lack aus einem Polysiloxan und vorteilhaft ein Sol-Gel-Lack aus einem aus einer alkoholischen Silan-Lösung, insbesondere einer Alkoxysilan-Lösung, und einer wässrigen kolloidalen Kieselsäure-Lösung hergestellten Polysiloxan. Polysiloxan ist dabei der Begriff für Polymere aus vernetzten Siloxanen. Das Polysiloxan wird insbesondere durch eine Kondensationsreaktion zwischen hydrolisierten und vernetzbaren Silanen, insbesondere Alkoxysilanen, und kolloidaler Kieselsäure erzeugt.

Die Kondensationsreaktion zwischen hydrolisierten Silanen, insbesondere Alkoxysilanen, untereinander, sowie hydrolisierten Silanen, insbesondere Alkoxysilanen, und kolloidaler Kieselsäure führt zur Ausbildung eines anorganischen Netzwerkes von Polysiloxanen. Gleichzeitig werden organische Gruppen, insbesondere Alkylgruppen bzw. einfache Alkylgruppen, über Kohlenstoffbindungen in das anorganische Netzwerk eingebaut. Die organischen Gruppen, bzw. die Alkylgruppen, nehmen jedoch nicht direkt an der Polymerisation bzw. der Vernetzung der Siloxane teil, d.h. sie dienen nicht zur Ausbildung eines organischen Polymersystems, sondern lediglich zur Funktionalisierung. Die Funktion liegt darin, dass die organischen Gruppen, insbesondere die Alkylgruppen, während des Sol-Gel-Prozesses an den Aussenseiten der Polysiloxane angehängt werden und dadurch eine nach aussen wasserabstossende Lage ausbilden, welche dem Sol-Gel-Lack eine ausgeprägte hydrophobe Eigenschaft verleiht.

Der beschriebene Sol-Gel-Prozess führt, wie erwähnt, durch gezielte Hydrolyse und Kondensation von Alkoxiden des Siliziums und Kieselsäure zu einem Sol-Gel-Lack aus einem anorganischem Netzwerk mit eingebauten Alkylgruppen. Die dadurch erhaltenen Polysiloxane sind deshalb eher den anorganischen Polymeren zuzuordnen.

Bei der Herstellung einer bevorzugten Ausführung eines Sol-Gel-Lackes als Schutzschicht wird zweckmässig von zwei Basislösungen A und B ausgegangen.

Die Lösung A ist eine alkoholische Lösung eines oder mehrerer verschiedener Alkoxysilane, wobei die Alkoxysilane in einem wasserfreien Medium in nicht hydrolisierter Form vorliegen. Als Lösungsmittel wird zweckmässig ein Alkohol, wie beispielsweise Methyl-, Ethyl-, Propyl- oder Butylalkohol und bevorzugt Isopropylalkohol, verwendet.

Die Alkoxysilane werden durch die allgemeine Formel XₙSi(OR)₄₋ₙ beschrieben, in welcher "R" ein einfaches Alkyl ist, vorzugsweise aus der Gruppe umfassend Methyl, Ethyl, Propyl und Buthyl. "X" ist zweckmässig ebenfalls ein Alkyl, vorzugsweise aus der Gruppe umfassend Methyl, Ethyl, Propyl und Buthyl. Zweckmässige Alkoxysilane sind beispielsweise Tetramethoxysilane (TMOS) und bevorzugt Tetraethoxysilan (TEOS) und Methyltrimethoxysilan (MTMOS) und weitere Alkoxysilane.

In besonders bevorzugter Ausführungsform wird die Lösung A aus Tetraethoxysilan (TEOS) und/oder Methyltrimethoxysilan (MTMOS) mit einem Methyl-, Ethyl- oder Propyl-Alkohol und insbesondere mit einem Isopropyl-Alkohol als Lösungsmittel zubereitet. Die Lösung A kann z.B. 25 - 35 Gew.-% (Gewichts-%), insbesondere 30 Gew.-%, TEOS und 15 - 25 Gew.-%, insbesondere 20 Gew.-%, MTMOS enthalten, beides gelöst in 40 - 60 Gew.-%, insbesondere 50 Gew.-%, Isopropyl-Alkohol.

Die Lösung B enthält in Wasser gelöste kolloidale Kieselsäure. In zweckmässiger Ausführung wird die Lösung B mittels Säure, vorzugsweise mittels Salpetersäure (HNO₃), auf einen pH-Wert zwischen 2,0 - 4, vorzugsweise zwischen 2,5 - 3,0 und insbesondere von 2,5 eingestellt.

Die verwendete Kieselsäure ist zweckmässig eine in saurem Milieu stabilisierte Kieselsäure, wobei der pH-Wert der Kieselsäure vorteilhaft bei 2 -4 liegt. Die Kieselsäure ist vorteilhaft möglichst alkaliarm. Der Alkaligehalt (z.B. Na₂O) der Kieselsäure liegt bevorzugt unter 0,04 Gew.-%.

Die Lösung B enthält beispielsweise 70 - 80 Gew.-%, insbesondere 75 Gew.-%, Wasser als Lösungsmittel und 20 - 30 Gew.-%, insbesondere 25 Gew.-%, kolloidale Kieselsäure. Die Lösung B ist zweckmässig mittels Salpetersäure (HNO₃) auf einen pH-Wert zwischen 2,0 - 3,5, vorzugsweise zwischen 2,5 - 3,0 und insbesondere von 2,5 eingestellt.

Das Zusammenführen und Mischen der beiden Basislösungen A und B führt in Gegenwart der Salpetersäure zu einer Hydrolysereaktion zwischen dem in Lösung B enthaltenen Wasser und den in Lösung A enthaltenen Alkoxysilanen.

Hydrolyse-Reaktion: Si(OR)ₙ + nH₂O → Si(OH)ₙ + nR(OH)

Gleichzeitig tritt eine Kondensationsreaktion ein, bei der unter Wasser-Abspaltung aus jeweils zwei Si-OH-Gruppen eine Siloxan-Bindung (Si-O-Si) aufgebaut wird. Durch fortschreitende Polymerisation entsteht dabei ein Netzwerk von Polysiloxanen, an welche Alkyl-Gruppen angegeliedert sind. Die neue Mischlösung liegt in einem gelförmigen Zustand vor.

Die beiden Lösungen A und B werden bevorzugt in einem Gewichtsverhältnis von 7:3 Teilen gemischt.

Der Sol-Gel-Lack wird zweckmässig in Gel-Form auf das Substrat, bzw. auf die entsprechende Oberfläche, aufgetragen bzw. abgeschieden und anschliessend getrocknet bzw. gehärtet. Der Trocknungsprozess besteht darin, die im Sol-Gel-Lack verbleibenden Wasser und Alkohole auszutreiben, wodurch der Sol-Gel-Lack aushärtet und eine korrosionsresistente und gegen chemische Stoffe beständige Schutzschicht auf der Metallfolienoberfläche entsteht.

Die Beschichtung erfolgt, beispielsweise durch Auftragen, Schleudern oder Spritzen, zweckmässig in einem kontinuierlichen Verfahren, welches für die Behandlung von in Bandform vorliegender Metallfolie geeignet ist. Besonders bevorzugte Beschichtungsverfahren sind das Sprühen, Spritzen, Tauchen bzw. Tauchziehbeschichten.

Insbesondere eignen sich Sol-Gel-Systeme, die beispielsweise unter dem Markennamen CERAPAINT des Unternehmens Akzo Nobel erhältlich sind, zur Ausbildung der Schutzschicht.

Schutzschichten (Sol-Gel-Lacke), die durch Auftragen eines Sol-Gel-Systems, also das Beschichten des eigentlichen Metallfoliensubstrats mit einem Sol-Gel-System, geschaffen werden, benötigen zu deren Herstellung einen Härtungs- bzw. Trocknungsprozess, bei dem das Sol-Gel-System in den beständigen Sol-Gel-Lack umgewandelt wird.

Das mit dem Sol-Gel-Lack beschichtete Substrat wird zweckmässig mittels Strahlung, wie UV-Strahlung, Elektronenstrahlung, Laserstrahlung, oder mittels Wärmestrahlung, wie IR-Strahlung (Infrarot), oder mittels Konvektionserwärmung oder einer Kombination der vorgenannten Trocknungs- bzw. Härtungsverfahren, getrocknet bzw. gehärtet.

Die Konvektionserwärmung kann zweckmässig durch eine Beaufschlagung mit erwärmten Gasen, wie Luft, Stickstoff, Edelgase oder Gemischen daraus, erfolgen. Die Sol-Gel-Lackschicht wird bevorzugt in einem Durchlaufofen getrocknet bzw. gehärtet.

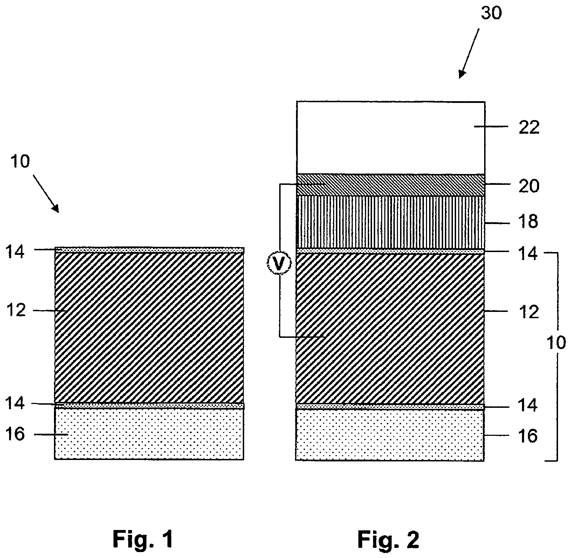

Weitere Vorteile, Merkmale und Einzelheiten der Erfindung ergeben sich aus der nachfolgenden Beschreibung bevorzugter Ausführungsbeispiele sowie anhand der Zeichnung; diese zeigt schematisch in
- Fig. 1: einen Querschnitt durch ein Substrat mit Schutzschicht;
- Fig. 2: einen Querschnitt durch eine auf demm Substrat von Fig. 1 aufgebaute Photovoltaik-Zelle.
Ein in Fig. 1 gezeigtes Substrat 10 weist eine Aluminiumfolie 12 einer Dicke von beispielsweise 150 µm auf. Die Reinheit des zur Herstellung der Folie eingesetzten Aluminiums ist z. B. Al 99,85. Die Folie ist hochglanzgewalzt und gegebenenfalls zumindest auf der später dem Aufbau einer Photovoltaik-Absorberschicht dienenden Seite zur Erzielung einer möglichst glatten Oberfläche zusätzlich elektrolytisch poliert. Die Aluminiumfolie 12 weist auf beiden Seiten lediglich eine nur wenige Nanometer dicke natürliche Oxidschicht 14 auf. Die später die Rückseite einer Photovoltaik-Zelle bildende Seite der Aluminiumfolie 12 ist mit einer Schutzschicht 16 einer Dicke von z. B. 1-2 µm aus einem Sol-Gel-Lack versehen.

Die hochglanzgewalzte Aluminiumfolie wird nach dem Walzen zur Entfernung von Oxidfilmen und Oberflächenkontaminationen mit einer sauren oder alkalischen Lösung durch Eintauchen oder Besprühen entfettet. Die erzielte Oberflächenqualität ist ausreichend für die direkte Beschichtung der entfetteten Aluminiumoberfläche mit dem Sol-Gel-Lack sowie für den direkten Aufbau einer Absorberschicht.

Ausgehend von dem in Fig. 1 gezeigten Substrat 10 in Form einer mit einem Sol-Gel-Lack beschichteten Aluminiumfolie 12 erfolgt der Aufbau einer Absorberschicht 18 direkt auf der glatten, der Schutzschicht 16 aus dem Sol-Gel-Lack gegenüberliegenden Seite der Aluminiumfolie 12, welche hier die rückseitige Kontaktschicht der in Fig. 2 gezeigten Photovoltaik-Zelle 30 bildet. Die geringe Dicke der natürlichen Oxidschicht 14 ermöglicht den direkten Aufbau der Absorberschicht 18 ohne zusätzlich Kontaktierungsschicht. Auf der Absorberschicht 18 ist eine von einer Schutzschicht 22 aus einem transparenten Kunststoff abgedeckte Frontkontaktschicht 20 aus transparentem Material angeordnet.

Die Schutzschicht 16 aus dem Sol-Gel-Lack schützt die Aluminiumfolie 12 vor einem chemischen Angriff bzw. vor Korrosion durch die bei der Herstellung und Aushärtung der Absorberschicht 18 auftretenden Dämpfe und Gase. Zudem führt die Schutzschicht 16 aus dem Sol-Gel-Lack zusätzlich zu einer Erhöhung der mechanischen Stabilität der während der Einwirkungszeit hoher Temperaturen weichen Aluminiumfolie 12.

## Patentansprüche

1. Substrat zur Herstellung von Photovoltaik-Zellen (30), wobei das Substrat eine Aluminiumfolie (12) enthält, welche beidseits eine wenige Nanometer dicke natürliche Oxidschicht aufweist,
**dadurch gekennzeichnet, dass**
eine erste Seite der Aluminiumfolie (12) hochglanzgewalzt ist und eine Oberflächenrauhigkeit Ra von weniger als 100 nm aufweist, wobei auf die Oxidschicht dieser ersten Seite der Aluminiumfolie (12) später eine Photovoltaik-Absorberschicht (18) direkt aufbaubar ist, und zur Verbesserung der chemischen Beständigkeit und des Korrosionswiderstandes bei erhöhter Temperatur die Oxidschicht der der ersten Seite gegenüberliegenden, zweiten Seite der Aluminiumfolie (12) mit einer Schutzschicht (16) aus einem Silizium-basierten Sol-Gel-Lack versehen ist.

2. Substrat nach Anspruch 1, **dadurch gekennzeichnet, dass** die erste Seite der Aluminiumfolie (12) eine Oberflächenrauhigkeit Ra von weniger als 50 nm aufweist.

3. Substrat nach Anspruch 1, **dadurch gekennzeichnet, dass** die Schutzschicht (16) eine Dicke zwischen 0.5 µm und 4 µm aufweist.

4. Photovoltaik-Zelle (30) mit einem Substrat (10) nach einem der vorangegangenen Ansprüche, wobei die Photovoltaik-Absorberschicht (18) direkt auf der natürlichen Oxidschicht (14) gebildet ist.

## Claims

1. Substrate for producing photovoltaic cells (30), wherein the substrate contains an aluminium film (12) which has on both sides a natural oxide layer which is a few nanometres thick, **characterised in that** a first side of the aluminium film (12) is rolled to produce a high-gloss finish and has a surface roughness Ra of less than 100 nm, wherein at a later stage a photovoltaic absorber layer (18) can be built up directly onto the oxide layer of this first side of the aluminium film (12), and in order to improve the chemical resistance and the resistance to corrosion at an elevated temperature the oxide layer of the second side of the aluminium film (12) opposite the first side is provided with a protective layer (16) of a silicon-based sol-gel paint.

2. Substrate according to claim 1, **characterised in that** the first side of the aluminium film (12) has a surface roughness Ra of less than 50 nm.

3. Substrate according to claim 1, **characterised in that** the protective layer (16) has a thickness between 0.5 µm and 4 µm.

4. Photovoltaic cell (30) with a substrate (10) according to one of the preceding claims, wherein the photovoltaic absorber layer (18) is formed directly on the natural oxide layer (14).

## Revendications

1. Substrat pour la fabrication de cellules photovoltaïques (30), ledit substrat comprenant une feuille d'aluminium (12) qui présente sur les deux faces une couche d'oxyde naturel de quelques nanomètres d'épaisseur,
**caractérisé en ce que**
une première face de la feuille d'aluminium (12) présente un fini miroir obtenu par laminage et une rugosité de surface Ra inférieure à 100 nm, sur la couche d'oxyde de cette première face de la feuille d'aluminium (12) pouvant être appliquée directement, à un moment ultérieur, une couche d'absorption photovoltaïque (18), et pour améliorer la stabilité chimique et la résistance à la corrosion à température élevée, la couche d'oxyde de la deuxième face, opposée à la première face, de la feuille d'aluminium (12) est pourvue d'une couche de protection (16) en un vernis sol-gel à base de silicium.

2. Substrat selon la revendication 1, **caractérisé en ce que** la première face de la feuille d'aluminium (12) présente une rugosité de surface Ra inférieure à 50 nm.

3. Substrat selon la revendication 1, **caractérisé en ce que** la couche de protection (16) présente une épaisseur comprise entre 0,5 µm et 4 µm.

4. Cellule photovoltaïque (30) comprenant un substrat (10) selon l'une des revendications précédentes, la couche d'absorption photovoltaïque (18) étant formée directement sur la couche d'oxyde naturel (14).
